# EUROPEAN PATENT APPLICATION

(11) **EP 1 245 696 A2**
(43) Date of publication of application: **02.10.2002**
(21) Application number: 02007235.1
(22) Date of filing: 28.03.2002
(51) Int. Cl.: C23C 16/50, C23C 14/34, C23F 4/00, H01J 37/32, C23C 16/44

(54) **Plasma resistant member**

(30) Priority: 30.03.2001 JP 2001099159; 06.03.2002 JP 2002060816
(71) Applicant: Toshiba Ceramics Co., Ltd., Shinjuku-ku, Tokyo 163-0023 (JP)
(72) Inventor: Tomonori, Uchimaru, Kanagawa (JP); Haruo, Murayama, Tougane-shi, Chiba (JP); Takashi, Tanaka, Hadano-shi, Kanagawa (JP); Keiji, Morita, Tougane-shi, Chiba (JP); Akira, Miyazaki, Hadano-shi, Kanagawa (JP)
(74) Representative: HOFFMANN - EITLE

(57) **Abstract**

The present invention provides a plasma resistant member having a reinforced mechanical strength and being sufficiently durable to exposure to a low pressure high density plasma. At least the surface of the alumina based material is formed of an oxide or composite oxide layer of a group IIIA element via an intermediate layer. It is preferable in the construction of the plasma resistant member that the intermediate layer comprises 10 to 80% by weight of the oxide or composite oxide of the group IIIA element in the periodic table and 90 to 20% by weight of alumina. The intermediate layer may also comprise a course ceramic with a porosity of 0.2 to 5%. It is also desirable that at least one of the conditions such as a difference in the thermal shrinkage ratio at 1600 to 1900°C of 3% or less is provided.

## Description

### BACKGROUND OF THE INVENTION

### 1. Field of the Invention

The present invention relates to a plasma resistant member. In particular, the present invention relates to a plasma resistant member having an excellent plasma resistance under a halogen based corrosive gas atmosphere.

### 2. Description of the Related Art

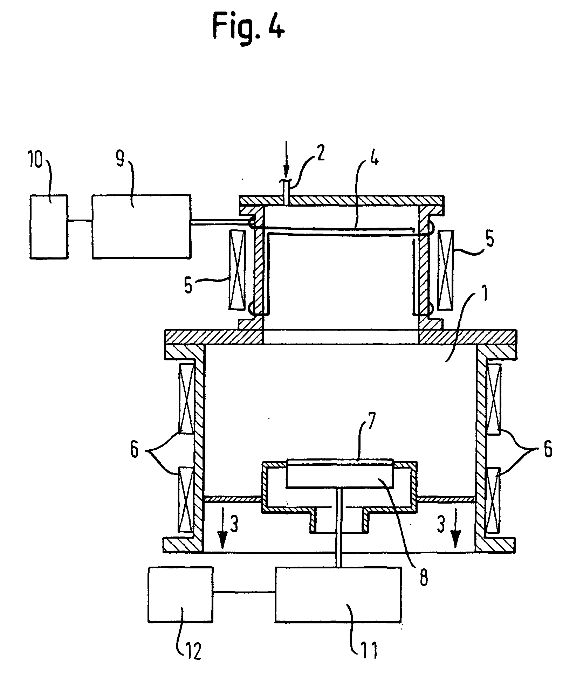

An etching apparatus and a sputtering apparatus that apply fine processing on a semiconductor wafer, or a CVD apparatus that deposits a film on the semiconductor wafer are used in the process for manufacturing a semiconductor device. Such manufacturing apparatus is provided with a plasma generation mechanism in order to form highly integrated circuits. These apparatuses include, for example, a helicon wave plasma etching apparatus as illustrated in the cross section in Fig. 4.

In Fig. 4, the reference numeral 1 denotes an etching processing chamber comprising an etching gas feed port 2 and evacuation port 3, and an antenna 4, an electromagnet 5 and a permanent magnet 6 are disposed outside of the circumference of the chamber. A lower electrode 8 that supports a semiconductor wafer 7 to be processed is also placed in the processing chamber 1. The antenna 4 is connected to a first high frequency power source 10 via a first matching network 9, while the lower electrode 8 is connected to a second high frequency power source 12 via a second matching network 11.

The wafer is etched as follows using this etching apparatus. First, the semiconductor wafer 7 is placed on the surface of the lower electrode 8 followed by feeding an etching gas from the etching gas fed port 2 after evacuating the inside of the processing chamber 1. Then, high frequency electric currents at a frequency of, for example, 13.56 MHz are supplied to the antenna 4 and lower electrode 8, respectively, from the respective high frequency power sources 10 and 12 via the corresponding matching networks 9 and 11. A high density of plasma is generated by generating a magnetic field in the processing chamber 1 by allowing a prescribed magnitude of electric current through the electromagnet 5. The etching gas is decomposed into an atomic state by this plasma energy, thereby etching a film formed on the surface of the semiconductor wafer 8.

A corrosive gas such as a chlorine based gas (for example boron trichloride BCl) or a fluorine based gas (for example carbon tetrafluoride CF₄) is used as the etching gas in this sort of apparatus. Accordingly, constituting members such as an inner wall of the processing chamber 1, a monitoring window, a microwave introduction window, a lower electrode 8, an electrostatic chuck a susceptor and so on that are exposed to the plasma under a corrosive gas atmosphere are required to be plasma resistant. Plasma resistant members that have been used for complying with such requirement include a alumina based sintered body, sapphire, a silicon carbide based sintered body and an aluminum nitride based sintered body. Particularly, the alumina based sintered body is featured in its availability and low cost of its row material, and is noticed from a practical point of view.

However, the plasma resistant member comprising a ceramic sintered body as described above is gradually corroded by being exposing with the plasma under the corrosive gas atmosphere to affect etching conditions due to changes of surface properties such as elimination of crystalline particles constituting the surface of the member. In other words, eliminated particles are adhered on the wafer 7 and lower electrode 8 and the like to adversely affect the accuracy of etching, thereby compromising performance and reliability of a semiconductor.

The CVD apparatus is also considered to be corrosion resistant, since it is exposed to a fluorine based gas such as nitrogen fluoride (NF₃) in the cleaning process.

A plasma resistant member made of an yttrium garnet (a so called YAG) sintered body has been proposed as a countermeasure of corrosion (for example Japanese Patent Laid-open Nos. 10-45461 and 10-236871). These Publications describe that the surface exposed to the plasma under a halogen based corrosive gas atmosphere mainly comprises of a composite oxide such as spinel, cordierite and yttrium aluminum garnet having a porosity of 3% or less while making the surface to have a center line mean surface roughness (Ra) of 1 µm or less.

However, while the yttrium aluminum garnet sintered body is excellent in plasma resistance, it has poor mechanical strength such as bending strength and fracture toughness. Poor mechanical strength (e.g brittleness) as used herein means that the member is liable to be damaged or fractured during handling such as attachment of the member in the etching apparatus. Therefore, it was a problem that the manufacturing cost of the manufacturing apparatus itself or the manufacturing cost of semiconductors become high in addition to a relatively high expense for the row material.

### SUMMARY OF THE INVENTION

Accordingly, it is an object of the present invention carried out for solving the foregoing problems to provide a plasma resistant material that is mechanically reinforced and is sufficiently durable to exposure to a low pressure high density plasma.

In a first aspect, the present invention provides a plasma resistant member comprising an alumina based material and at least a surface to be exposed to a plasma, the surface comprising a surface layer including an oxide or a composite oxide of a group IIIA element in the periodic table, and means for absorbing thermal expansion difference provided between the alumina based material and the surface layer.

The absorbing means in the first aspect of the present invention may comprise one or a combination of means for providing an intermediate layer, for providing a composition having a gradient, for adjusting a porosity, and for adjusting the thickness of each layer. The mean for providing the intermediate layer is most preferable among these means.

The intermediate layer according to the first aspect of the present invention preferably comprises 10 to 80% by weight of an oxide or a composite oxide of a group IIIA element in the periodic table, and 90 to 20% by weight of alumina.

The difference of the thermal shrinkage ratio between the alumina based material and the layer containing the oxide or composite oxide of the group IIIA element in the periodic table formed on the surface of the alumina based material is preferably 3% or less at 1600 to 1900°C in the first aspect of the present invention. It is not preferable that the difference of the thermal shrinkage ratio exceeds 3% since cracks are generated in the sintered body.

In a second aspect of the present invention, the present invention provides a plasma resistant member comprising an alumina based material and at least a surface to be exposed to a plasma, and the surface comprises a surface layer including an oxide or a composite oxide of a group IIIA element in the periodic table and means for absorbing thermal expansion difference being provided between the alumina based material and the surface layer. The content of the oxide or composite oxide of the group IIIA element in the periodic table in the surface layer is 70% by weight or more.

The absorbing means in the second aspect of the present invention may comprise one or a combination of means for providing an intermediate layer, for providing a composition having a gradient, for adjusting a porosity, and for adjusting the thickness of each layer. The mean for providing the intermediate layer is most preferable among these means.

It is preferable in the second aspect of the present invention that the content of the oxide or composite oxide of the group IIIA element in the periodic table continuously changes in the direction of depth in the intermediate layer and surface layer. It is particularly preferable that the rate of change of the content of the oxide or composite oxide of the group IIIA element in the periodic table is 30% or less for every 50 µm in the direction of depth in the intermediate layer and surface layer. A rate of change of the content of the component exceeding 30% is not preferable since a difference in the physical property (difference of thermal expansion) arises between the oxide or composite oxide of the group IIIA element in the periodic table in the surface and alumina in the material.

In a third aspect, the present invention provides a plasma resistant member comprising an alumina based material, a dense surface layer with a porosity of 0.1% or less containing an oxide or a composite oxide of a group IIIA element in the periodic table, and an intermediate layer comprising an inexact mass ceramic layer with a porosity of 0.2 to 5% located between these two layers.

It is not preferable in the third aspect of the present invention that the porosity in the intermediate layer is either lower or higher than the range described above, since cracks may be generated due to insufficient relaxation of stress in the former case while mechanical strength may be decreased in the latter case.

The thickness of the dense surface layer containing the oxide or composite oxide of the group IIIA element in the periodic table is preferably 0.01 to 0.50 mm, 0.03 to 0.20 mm in particular, in the third aspect of the present invention. It is not preferable that the thickness is either smaller or larger than the range above, since the surface layer is not durable in a corrosive gas atmosphere in the former case and the manufacturing cost increases in the latter case.

In a fourth aspect, the present invention provides a plasma resistant member comprising an alumina based material and a surface layer including an oxide or a composite oxide of a Group IIIA element in the periodic table formed on the surface of the alumina based material. The surface layer containing the oxide or a composite oxide of the Group IIIA element in the periodic table formed on the surface of the alumina based material has a porosity of 0.2 to 5%.

It is not preferable in the fourth aspect of the present invention that the porosity of the surface layer containing the oxide or composite oxide of the Group IIIA element in the periodic table is lower than the range above, since the layer becomes so dense that stress is insufficiently relaxed to generate cracks. It is also not preferable that the ratio is higher than the range above, since the voids penetrates to the alumina based material to arise selective etching of alumina, thereby peeling the layer of the oxide or composite oxide of the group IIIA element in the periodic table to cause generation of particles.

The thickness of the surface layer containing the oxide or composite oxide of the Group IIIA element in the periodic table formed on the surface of the alumina based material is preferable 0.01 to 0.50 mm, 0.03 to 0.20 mm in particular, in the fourth aspect of the present invention. It is not preferable that the thickness of the surface layer is either lower or higher than the range above, since the thickness is not sufficient for enduring the corrosive gas in the former case while the manufacturing cost would be increased in the latter case.

The present invention is based on the following facts .

The alumina based material (a sintered body of an alumina based ceramic) was found to exhibit a plasma resistance sufficiently durable to exposure to a low pressure high density plasma when the material is coated with an oxide or a composite oxide of a group IIIA element in the periodic table.

Sintered bodies of the oxide or composite oxide of the Group IIIA element is highly resistant to corrosion due to the following reasons. A fluoride of the group IIIA element is formed when the oxide or composite oxide of the group IIIA element is exposed to a fluorine gas. Since the fluoride of the Group IIIA element is hardly evaporated off due to its high melting point or its high boiling point, besides the fluoride layer prevents a reaction with a fluoride radical from advancing, thereby exhibiting a high corrosion resistance.

However, generation of cracks was observed when a sintered body of the oxide or composite oxide of the group IIIA element is formed on the surface of the alumina based material due to a difference of the thermal expansion ratio between the material and sintered body. Therefore, it was difficult to realize a member having a high corrosion resistance as expected.

The first, second and third aspects of the present invention were obtained, through intensive studies, by taking notice of the facts that cracks can be prevented from generating by relaxing the difference in the thermal expansion ratio by allowing an intermediate layer that serves as an absorbing layer to exist between the surface of the alumina based material and the sintered body of the oxide or composite oxide of the group IIIA element.

Furthermore, the fourth aspect of the present invention was achieved by finding that cracks can be prevented from generating without providing an intermediate layer between the alumina based material and the sintered body of the oxide or composite oxide of the group IIIA element, when the porosity in the sintered body of the oxide or composite oxide of the group IIIA element on the surface falls within a specified range.

### BRIEF DESCRIPTION OF THE DRAWINGS

Fig. 1 is an electron microscopic photograph showing an enlarged cross sectional structure of the plasma resistant member according to one example of the present invention;

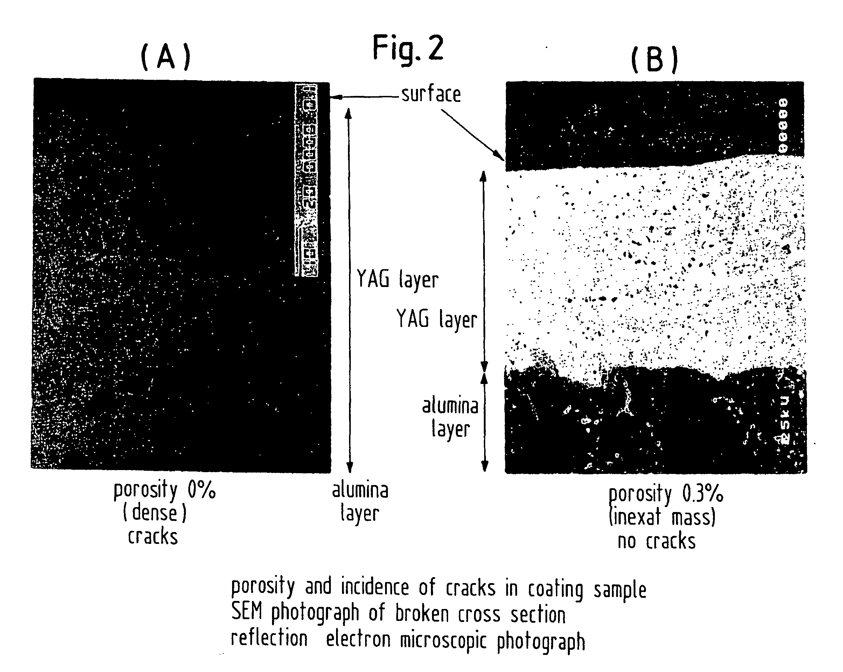

Fig. 2 is an electron microscopic photograph showing an enlarged cross sectional structure of the plasma resistant member according to another example of the present invention;
Fig. 3 is an electron microscopic photograph showing an enlarged cross sectional structure of the plasma resistant member according to a different example of the present invention; and
Fig. 4 is a cross sectional view illustrating a plasma etching apparatus.

### DESCRIPTION OF THE PREFERRED EMBODIMENTS

### (First embodiment)

The first embodiment of the present invention will de described hereinafter.

An intermediate layer comprising 10 to 80% by weight of an oxide or a composite oxide of a group IIIA element in the periodic table and 90 to 20% by weight of alumina is formed between an alumina based material and a layer of a sintered body as a surface layer containing the oxide or composite oxide of the group IIIA element in the periodic table in this embodiment.

The alumina based material in this embodiment is a sintered body of alumina (alumina based ceramic) comprising at least 90% by weight of alumina.

The layer of the sintered body as a surface layer containing the oxide or composite oxide of the group IIIA element in the periodic table for covering the surface of the alumina based material to be exposed to a plasma comprises, for example, an oxide of Sc, Y, Er, La, Ce, Ne, Yb, Dy, Eu or Lu, or a composite oxide mainly comprising these elements.

Examples of the composite oxide as used herein include a composite material of a group IIIA element in the periodic table such as Sc, Y, Er, La, Ce, Ne, Yb, Dy, Eu or Lu and an Al oxide. The composite oxide takes a perovskite type, merrillite type or garnet type crystal structure. The thickness of the sintered body layer is preferably adjusted to be at least 0.03 mm for stress relaxation.

The intermediate layer to be inserted between the alumina based material and the sintered body layer as a surface layer containing the oxide or composite oxide of the group IIIA element in the periodic table in this embodiment is responsible for adhesion, integration or absorbing action of the thermal expansion and shrinkage of the sintered body layer as a surface layer containing the oxide or composite oxide of the group IIIA element in the periodic table against the alumina based material. The intermediate layer is preferably a multiple layer or a composite layer that exhibits thermal expansion or shrinkage similar to that of the sintered body layer as a surface layer containing the oxide or composite oxide of the group IIIA element in the periodic table.

In particular, it is preferable in the alumina/oxide or composite oxide system of the element in the periodic table that the composition ratio of alumina is decreased continuously or stepwise from the surface side of the alumina based material to the side of the sintered body layer containing the oxide or composite oxide of the group IIIA element. For example, preferable ranges of 90 to 20% by weight of alumina and 10 to 80% by weight of the oxide or composite oxide of the group IIIA element in the periodic table, or a more preferable range of 30 to 70% by weight of the latter when the intermediate layer is a monolayer, are selected, and the compositions thereof are lowered continuously or stepwise, if necessary. The composition difference between the two adjoining layers is preferably adjusted to be 30% or less, more preferably to be 25% or less.

In the relation between the alumina based material and intermediate layer in this embodiment, adhesion and integration between them are enhanced and potential peeling between them is eliminated when the row material powder of them has a specific surface area of 1.0 to 10.0 m²/g. Potential peeling is particularly eliminated when the difference of the thermal shrinkage ratio between the alumina based material and intermediate layer is 3% or less at 1600 to 1900°C. The smaller difference of the thermal shrinkage ratio of 2% or less, or 1% or less, is preferable. In addition, the difference of the thermal shrinkage ratio between the alumina based material and the oxide layer or the composite oxide layer of the group IIIA element is adjusted to be 3% or less, preferably to be 2% or less, and more preferably to be 1% or less at 1600 to 1900°C.

In a construction in which 100% purity of an yttrium-aluminum garnet layer is laminated and sintered on the alumina based material, an intermediate layer having an intermediate composition of the compositions of the layers above was inserted between the alumina based material and yttrium-aluminum garnet layer. The relations between the difference of the thermal shrinkage ratio at 1600 to 1900°C and the states of the laminated sintered bodies (generation of cracks or crevices) obtained as described above are shown in Table 1. The results indicate that a sintered body being free from troubles such as peeling is obtainable when the difference of the thermal shrinkage ratio is 3% or less.

**TABLE 1**

| DIFFERENCE OF THERMAL SHRINKAGE RAIO | STATE OF SINTERED BODY |
|---|---|
| 0.00 TO LESS THAN 1.00% | NO PROBLEM |
| 1.00 TO LESS THAN 2.00% | NO PROBLEM |
| 2.00 TO LESS THAN 3.00% | NO PROBLEM |
| 3.00 TO LESS THAN 4.00% | GENERATION OF CRACKS WITH A LENGTH OF SEVERAL mm |
| 4.00 TO LESS THAN 5.00% | GENERATION OF CRACKS WITH A LENGTH OF SEVERAL TENS mm |
| 5.00 TO LESS THAN 6.00% | GENERATION OF CRACKS WITH A LENGTH OF SEVERAL TENS mm |
| 6.00 TO LESS THAN 7.00% | PEELING AT BOUNDARY |
| 7.00 TO LESS THAN 8.00% | PEELING AT BOUNDARY |

The state of the laminated sintered body was investigated when an intermediate layer having an intermediate composition of the alumina based material and the surface layer was inserted between the material and surface layer before firing, wherein the surface layer fired on the alumina based material is selected from erbium oxide (Er₂O₃), yttrium oxide (Y₂O₃), yttrium-aluminum garnet (YAG), europium oxide (Eu₂O₃), gadolinium oxide (Gd₂O₃), dysprosium oxide (Dy₂O₃), samarium oxide (Sm₂O₃) or cerium oxide (Ce₂O₃). The results showed that problems such as peeling were not occurred when erbium oxide, yttrium oxide or yttrium-aluminum garnet was used. An improvement of yield was noticed when two or more layers of europium oxide, gadolinium oxide, dysprosium oxide or cerium oxide were provided, and the yield exceeds 90% when four or more layers were provided.

The method for integrating the alumina based material, intermediate layer and surface layer comprising an oxide or a composite oxide of a group IIIA element include, for example, (a) sintering of a composite layer comprising an alumina layer and a mixed layer prepared by varying the mixing ratio of alumina and an oxide or a composite oxide of a group IIIA element, (b) deposition and firing of an intermediate layer and an oxide or a composite oxide layer of a group IIIA element on the alumina material layer by a chemical vapor deposition method, or (c) deposition and firing by a physical vapor deposition method (a reduced pressure CVD method, a plasma CVD method, an ion plating method, a sputtering method and the like).

As described above, in this embodiment, the material is essentially formed of an alumina based sintered body, and the surface exposed to a plasma is coated with a layer of an oxide or a composite oxide of a group IIIA element. In other words, the alumina based sintered body having excellent mechanical properties such as bend strength and toughness against fracture is used as a material, while the surface of the material exposed to the plasma is coated with an oxide or a composite oxide of the group IIIA element excellent in plasma resistance. In addition, an intermediate layer for relaxing differences of thermal expansion and shrinkage ratios between the material and oxide or composite oxide coating layer is inserted between the material surface and the oxide or composite oxide layer of the group IIIA element in the periodic table.

### (Second embodiment)

The second embodiment of the present invention will be described hereinafter.

According to this embodiment, at least the surface of the alumina based material exposed to a plasma is formed of a surface layer including an oxide or a composite oxide of a group IIIA element in the periodic table via an intermediate layer, wherein the content of the oxide or composite oxide of the group IIIA element in the periodic table is 70% by weight or more. Since corrosion resistance becomes insufficient when the content of the oxide or composite oxide of the group IIIA element in the periodic table in the surface layer is less than 70% by weight, the more preferable range thereof is 90% by weight or more.

It is particularly preferable that the content of the oxide or composite oxide of the group IIIA element in the periodic table in the intermediate layer and surface layer continuously changes in the direction of depth in each layer.

The rate of change of the content of the oxide or composite oxide of the group IIIA element in the periodic table is more preferably 30% or less for every 50 µm in the direction of depth in the intermediate layer and surface layer.

The particularly preferable oxide or composite oxide of the group IIIA element in the periodic table is yttrium-aluminum garnet in this embodiment.

A high plasma resistance may be maintained by allowing the content of an oxide or a composite oxide of the group IIIA element in the periodic table to be increased with a gradient from the interior to the surface of the sintered body, while making the rate of change of the content of the oxide or composite oxide of the group IIIA element in the periodic table for every 50 µm in the direction of depth to be 30% or less . AS a result, cracks due to the differences of the firing shrinkage ratio and thermal expansion ratio between the alumina based material and the oxide or composite oxide of the group IIIA element in the periodic table can be suppressed from generating. However, corrosion resistance is deteriorated due to a small content of the oxide or composite oxide of the group IIIA element in the periodic table in the area from the surface to a depth of 100 µm, when the rate of change of the content of the oxide or composite oxide of the group IIIA element in the periodic table for every 50 µm in the direction of depth is higher than 30%. Furthermore, cracks may be readily generated because the differences of the firing shrinkage and thermal expansion increase when the rate of change of the content of the oxide or composite oxide of the group IIIA element in the periodic table is large. Therefore, the more preferable rate of change of the content of the oxide or composite oxide of the group IIIA element in the periodic table for every 50 µm is 10% or less.

Continuous changes of the compositions of the intermediate layer and surface layer may be formed, for example, by employing the following methods.

An example for forming a surface layer comprising yttrium-aluminum garnet is elucidated as follows. A slurry as a starting material is obtained by mixing an alumina powder, an yttrium compound as an yttrium-aluminum garnet source such as yttrium chloride, yttrium acetate or yttrium nitrate, and a magnesium compound as a MgO source such as magnesium sulfate or magnesium nitrate in water. Then, the slurry is granulated with a spray dryer after adding a molding aid, followed by applying a method known in the art such as press-molding, die-molding, extrusion molding or injection molding to obtain a molded body. The molded body obtained is sintered, after degreasing if necessary, at 1600 to 1850°C in the air, in a reducing atmosphere or in vacuum to from yttrium-aluminum garnet. Since yttrium-aluminum garnet flows from the inside to the surface of the fired body during the sintering process, a sintered body having a gradient of the content of yttrium-aluminum garnet can be obtained.

It is also possible in the manufacturing method described above to obtained a sintered body with no voids by sintering by means of HIP or HP.

### (Third embodiment)

The third embodiment of the present invention will be described hereinafter.

The difference of the thermal expansion between the alumina based material and the surface layer including an oxide or a composite oxide of a group IIIA element in the periodic table is relaxed in this embodiment by inserting an intermediate layer having a dense structure between the alumina based material and the surface layer including an oxide or a composite oxide of a group IIIA element in the periodic table, thereby enabling a coating member free from cracks to be manufactured.

A remnant stress is generated due to a difference of linear expansion coefficient during firing to arise cracks in the fired body when alumina is coated with a layer comprising an oxide or a composite oxide of a group IIIA element in the periodic table having a porosity of 0.1% or less. For avoiding cracks from generating, an inexact mass ceramic layer having a porosity of 0.2 to 5% is used as the intermediate layer in this embodiment.

The material of the intermediate layer as an inexact mass ceramic layer preferably has as affinity with each of the alumina based material and surface layer including an oxide or a composite oxide of a group IIIA element. In particular, the intermediate layer preferably comprises layers of an alumina based material and an oxide or a composite oxide of a group IIIA element, or a mixed layer thereof, in order to prevent cracks from generating.

A means for controlling the particle size and shape of the row material powder is employed for forming the inexact mass ceramic layer as described above.

The porosity is measurable by analyzing a cross sectional photograph of the sample in this embodiment.

### (Fourth embodiment)

The fourth embodiment of the present invention will be described hereinafter.

In this embodiment, the differences in the shrinkage ratio and thermal expansion ratio between the alumina based material and the layer containing an oxide or a composite oxide of a group IIIA element are controlled by controlling the porosity of the surface layer containing the oxide or composite oxide of the group IIIA element, thereby preventing cracks from generating after firing.

The method for forming a layer containing a high concentration of the oxide or composite oxide of the group IIIA element with a thickness of 0.01 mm or more on the surface of alumina comprises (1) forming a layer containing a high concentration of the oxide or composite oxide of the group IIIA element on the surface of alumina by independently filling, molding and firing a granulated alumina powder and a powder of the oxide or composite oxide of the group IIIA element, and (2) molding and calcining the granulated alumina powder, and coating a slurry of YAG on the fired body followed by additional firing. However, cracks are liable to be formed after firing, because there are some differences in the shrinkage ratio and thermal expansion ratio between the alumina based material and the layer containing the oxide or composite oxide of the group IIIA element during firing. For avoiding the cracks from generating, the porosity in the surface layer is controlled.

The cracks may be prevented from generating in this embodiment by employing an inexact mass ceramic layer with a porosity of 0.2 to 5% as the surface layer containing the oxide or composite oxide of the group IIIA element.

A porosity of less than 0.2% is responsible for making the surface layer dense so as to generate cracks in this embodiment. When the porosity of the surface layer is larger than 5%, on the other hand, the voids penetrate through the surface layer to the alumina body, and the alumina body is selectively etched to peel off the layer of the oxide or composite oxide of the group IIIA element or group IIIA element, thereby generating particles.

The method described in the third embodiment may be used for measuring the porosity in this embodiment.

The porosity in the surface layer may be controlled within the range of this embodiment by controlling the particle size of the row material powder, by adding particles having different shapes, or by adding a foaming agent.

### (Other modified embodiments)

In use of the members to be exposed to a plasma atmosphere, peeling of the coating layer from the member due to thermal effects and action or damages and collapse of the surface by cleaning may be solved, or potential contamination with particles may be eliminated by the construction as described above. Accordingly, these and other embodiments may be effective for manufacturing high performance and reliable semiconductors by suppressing or preventing manufacturing apparatus and manufacturing cost from increasing without adversely affecting the quality and accuracy of film deposition.

### Examples

Examples of the present invention will be described hereinafter.

### (Example 1)

Alumina particles with a purity of 99.5% and means particle size of 0.3 µm, and yttria with a purity of 99.5% and means particle size of 0.3 µm were mixed in a composition ratio (% by weight) as shown in Table 2. An appropriate volume of ion exchange water and 2 parts by weight of polyvinyl alcohol were added to the mixed powder followed by stirring and mixing for 12 hours with a ball mill to prepare seven kinds of slurries . Then, granulated powders with a particle diameter of about 100 µm were prepared from respective slurries prepared as described above using a spray dryer.

**TABLE 2**

| SAMPLE | ALUMINA PARTICLE | YTTRIA PARTICLE |
|---|---|---|
| 1a | 100 | - |
| 1b | 99 | 1 |
| 1c | 95 | 5 |
| 1d | 90 | 10 |
| 1e | 50 | 50 |
| 1f | 20 | 80 |
| 1g | - | 100 |

The granulated powders 1a, 1b, 1c, 1d, 1e, 1f and 1g were filled by laminating in this order, and molded with a uniaxial press under a pressure of 98.1 MPa (1000 kgf/cm²) to obtain a molded body with a thickness of 10 mm, a width of 100 mm and a length of 100 mm. The molded body was sintered and fired for 2 hours at 1600 to 1900°C to obtain a laminated sintered body of alumina (material)/mixed system of alumina and yttria (intermediate layer)/yttria. The surface of yttria of this laminated sintered body was ground to a surface roughness (Ra) of 0.01 µm or less.

A test piece with a thickness of 2 mm and an area of 10 × 10 mm square was cut from the laminated sintered body. The test piece was attached to a parallel plate type RIE apparatus, and was subjected to a plasma exposure test at a frequency of 13.56 MHz under a severe condition of a high frequency source of 500W, a high frequency bias of 40W, a CF₄ gas flow rate of 100 cc/min, a gas pressure of 0.5332 Pa (4 mTorr), a plasma density of 1.7 × 10¹¹ atoms/cm², and an ion impact energy of 88 eV to obtain an etching rate of 10 nm/hour. This laminated sintered body was excellent in mechanical durability without causing any damages in handling for cleaning.

The laminated sintered body described above was composed of an alumina based material with a thickness of 7 mm, an alumina-yttria mixed layer (an intermediate layer) with a thickness of 0.1 mm, and an yttria based layer with a thickness of 0.1 mm. The specific surface areas of the yttrium-aluminum garnet powder and alumina powder as row material powders of the intermediate layer and the alumina based material were 3 m²/g and 5 m²/g, respectively.

### (Examples 2 to 7)

Seven kinds of granulated powders corresponding to the samples 1a, 1b, 1c, 1d, 1f, 1e and 1g in Example 1 were prepared by the same conditions as in Example 1, except that erbium oxide (Er₂O₃; Example 2), lanthanum oxide (La₂O₃; Example 3), cerium oxide (Ce₂O₃; Example 4), europium oxide (Eu₂O₃; Example 5), dysprosium oxide (Dy₂O₃; Example 6), and yttrium-aluminum garnet (Example 7) were used in place of the yttria particle. Each granulated power was filled and laminated in a die in a prescribed order, and the laminate was pressed at a pressure of 98,1 MPa (1000 kgf/cm²) with a uniaxial press, thereby obtaining each molded body with a thickness of 10 mm, a width of 100 mm and a length of 100 mm.

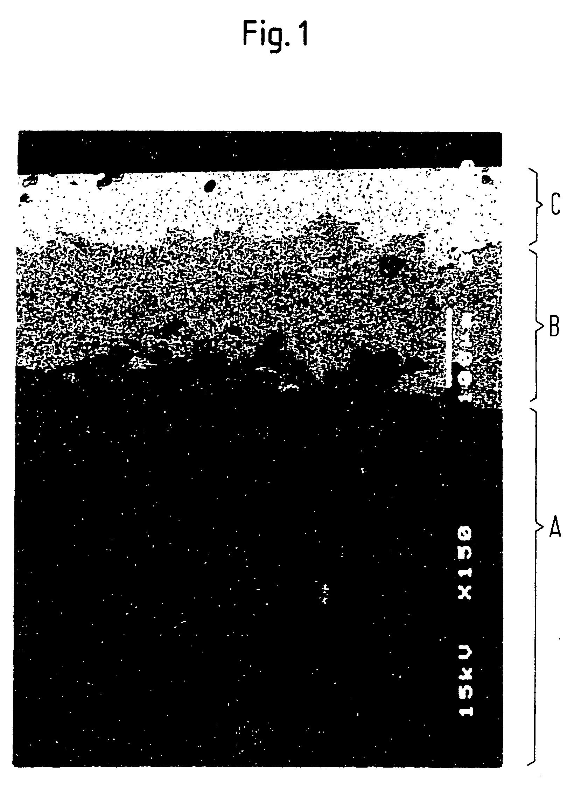

Each molded body above was sintered and fired at 1600 to 1800°C for 2 hours to obtain a corresponding laminated sintered body of such as, for example, alumina based material/mixed layer of alumina and lanthanum oxide/lanthanum oxide based layer. The surface layer of, for example, lanthanum oxide of each laminated sintered body was ground to a surface roughness (Ra) of 0.01 µm or less. Each of these laminated sintered body was composed of an alumina material with a thickness of 7 mm, an intermediate layer with a thickness of 0.1 mm and a coating layer with a thickness of 0.1 mm. Fig. 1 is an electron microscope photograph showing a laminated cross sectional structure comprising the granulated particle 1e in Example 1 using yttrium-aluminum garnet (Example 7) among these laminated sintered bodies . In Fig. 1, A denotes an alumina based material, B denotes an intermediate layer and C denotes an yttrium-aluminum garnet layer.

A sample piece with a thickness of 2 mm and an area of 10 × 10 mm was cut from each laminated sintered body, and attached to a parallel plate RIE apparatus . The sample was subjected to a plasma exposure test at a frequency of 13.56 MHz under a sever condition of a high frequency source of 500W, a high frequency bias of 40W, a CF₄ gas flow rate of 100 cc/min, a gas pressure of 0.5332 Pa (4 mTorr), a plasma density of 1.7 × 10¹¹ atoms/cm³ and an ion impact energy of 88 eV to obtain an etching rate as shown in Table 3. All of these laminated sintered bodies had excellent mechanical durability without arising any damages in a handling process such as cleaning.

**TABLE 3**

| SAMPLE | ETCHING RATE |
|---|---|
| EXAMPLE 2 | 15 nm/hour |
| EXAMPLE 3 | 20 nm/hour |
| EXAMPLE 4 | 15 nm/hour |
| EXAMPLE 5 | 10 nm/hour |
| EXAMPLE 6 | 10 nm/hour |
| EXAMPLE 7 | 10 nm/hour |

### (Examples 8 to 10, Comparative Examples 1 and 2)

Alumina particles with a purity of 99.99% and an yttrium-aluminum garnet powder with a purity of 99.9% were mixed with water in a composition ratio as shown in Table 4 by adding 0.1% by weight of MgSO₄·7H₂O. The mixture was granulated with a spray dryer by adding a molding binder. After molding the granulated powder into a plate under a pressure of 98.1 MPa (1000 kgf/cm²) and degreasing at 1100°C, the molded body was fired at a temperature shown in Table 4. A ceramic sintered body having a gradient increment of the amount of yttrium-aluminum garnet from the inside to the surface of the sintered body was thus obtained.

The sintered body obtained was processed into a dimension of 10 × 10 × 2 mm, and one face of it was subjected to mirror grinding. Half of the surface of this sample was masked with a fluorinated resin tape, the sample obtained was etched for 2 hours with a CF₄ plasma gas using a helicon plasma apparatus. The gas pressure and high frequency electric power used were 1.33 Pa (10 mTorr) and 500W, respectively. After etching, the step height between the masking surface and exposed surface was measured with a step height measuring device to calculate the etching rate. The results are shown in Table 4.

The sintered body obtained as described above was processed into a size of 20 × 20 × 2 mm, and was placed into an air furnace heated at 400°C for 10 minutes. After taking the sample out of the furnace, it was cooled to room temperature. This heat cycle was repeated 100 times to confirm cracks, if any. The results are also shown in Table 4.

**TABLE 4**

| NO OF EXAMPLE | AMOUNT OF YAG ADDED | SINTER ING TEMP. | COATING RATIO OF YAG SURFACE | RATE OF CHANGE OF YAG CONTENT FOR EVERY 50 µm | ETCHING RATE (nm/h) | INCIDENCE OF CRACKS IN HEAT CYCLE |
|---|---|---|---|---|---|---|
| EXAMPLE 8 | 10 wt% | 1800°C | 90% | 20% | 10 | NONE |
| EXAMPLE 9 | 10 wt% | 1780°C | 70% | 20% | 20 | NONE |
| COMPARATIVE EXAMPLE 1 | 10 wt% | 1750°C | 50% | 20% | 80 | NONE |
| EXAMPLE 10 | 5 wt% | 1800°C | 90% | 30% | 15 | NONE |
| COMPARATIVE EXAMPLE 2 | 3 wt% | 1800°C | 90% | 50% | 30 | YES |

### (Example 11)

A row material powder of alumina, MgO, pure water and alumina balls were placed in a pot, and the mixture was mixed and crushed by rotating the pot for 12 hours. The slurry obtained was formed into a granulated powder with a particle diameter of about 100 µm with a spray dryer. The granulated powder of alumna was molded into a disk with a diameter of 80 mm and a thickness of 10 mm with CIP (under a pressure of 14.7MPa), followed by firing at 900°C to form into a calcined body.

In another run, a mixed slurry was obtained by placing a row material powder of alumina, a YAG powder, a dispersing agent, pure water and alumina balls in a pot, followed by rotating the pot for 12 hours for mixing and crushing.

In a different run, a YAG slurry was obtained by placing a YAG powder, a dispersing agent, pure water and alumina balls in a pot, followed by rotating the pot for 12 hours for mixing and crushing.

The mixed slurry of YAG and alumina, and the YAG slurry were successively coated on the alumina calcined body obtained in the foregoing step, followed by calcining again after drying at 50°C for 12 hours.

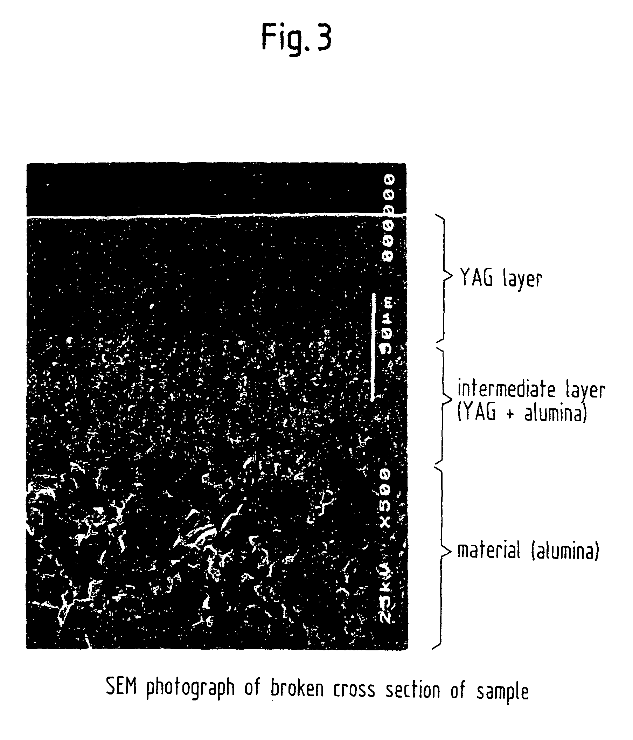

The calcined body coated as described above was fired at 1700 to 1850°C for 4 hours, thereby obtaining a sintered body having a cross section as shown in Fig. 3.

A test piece with a thickness of 2 mm and an area of 10 × 10 mm was cut from the sintered body. The test piece was attached to a parallel plate type RIE apparatus, and was subjected to a plasma exposure test at a frequency of 13.56 MHz under a severe condition of a high frequency source of 500W, a high frequency bias of 40W, a CF₄ gas flow rate of 100 cc/min, a gas pressure of 0.5332 Pa (4 mTorr), a plasma density of 1.7 × 10¹¹ atoms/cm³, and an ion impact energy of 88 eV.

The sample obtained was paced in a drying chamber and, after holding a temperature of 170°C for 15 minutes, it was placed on an alumina plate at 25°C. This heat cycle test was repeated until cracks appear on the sample.

The results are shown in Table 5.

**TABLE 5**

| EXAPLE NO | COATING | ETCHING RATE | HEAT CYCLE TEST |
|---|---|---|---|
| COMPARATIVE EXAMPLE 3 | PURE ALUMINA | 100 nm/h | - |
| EXAMPLE 11 | ALUMIA + YAG COAT | 10 nm/h | 200 TIMES OR MORE |

### (Example 12)

A row material powder of alumina, MgO, pure water and alumina balls were placed in a pot, and were mixed and crushed by rotating the pot for 12 hours. The slurry obtained was formed into a granulated powder with a particle diameter of 100 µm using a spray dryer. The granulated alumina powder was molded into a disk with a diameter of 80 mm and a thickness of 10 mm with CIP (under a pressure of 147.0 MPa = 1500 kg/cm²), followed by firing at 900°C to form a calcined body.

A dispersing agent and pure water was added into each powder of YAG, Y₂O₃, Er₂O₃, La₂O₃, Ce₂O₃, Eu₂O₃ and Dy₂O₃, and each mixture was placed into a pot followed by rotating the pot for 12 hours for mixing and crushing, thereby obtaining a slurry.

The slurry containing, for example, YAG was coated on the foregoing calcined body of alumina by spraying, and the coated calcined body was calcined again at 50°C for 12 hours.

The calcined body above as fired at 1700 to 1850°C for 2 hours, thereby obtaining a fired body having a cross section shown in Fig. 4. Fig. 4 shows that, although the fired body having a dense YAG layer with a porosity of zero % generated many cracks, the fired body with a porosity of 0.3% showed no cracks at all.

The fired body above was subjected to a plasma exposure test under the condition below using a parallel plate type plasma etching apparatus. A test piece with a thickness of 2 mm and an area of 10 × 10 mm was cut from the fired body, which was attached to a parallel plate type RIE apparatus at a frequency of 13.56 MHz to subject the test piece to a plasma exposure test under a severe condition comprising a high frequency source of 500W, a high frequency bias of 40W, a CF₄ gas flow rate of 100 cc/min, a gas pressure of 0.5332 Pa (4 mTorr), a plasma density of 1.7 × 10¹¹ atoms/cm³, and an ion impact energy of 88 eV.

The results are shown in Table 6.

**TABLE 6**

| EXAMPLE | SURFACE LAYER MATERIAL | ETCHING RATE |
|---|---|---|
| EXAMPLE 12 | YAG | 10 nm/h |
| EXAMPLE 13 | Y₂O₃ | 10 nm/h |
| EXAMPLE 14 | Er₂O₃ | 15 nm/h |
| EXAMPLE 15 | La₂O₃ | 20 nm/h |
| EXAMPLE 16 | Ce₂O₃ | 15 nm/h |
| EXAMPLE 17 | Eu₂O₃ | 10 nm/h |
| EXAMPLE 18 | Dy₂O₃ | 10 nm/h |

The present invention is not restricted to the examples as set forth above, and various modifications thereof are possible within a range not departing from the spirit of the present invention. For example, the thickness and shape of the alumina based material, the material and composition of the intermediate layer, and the material and thickness of the group III element oxide layer are appropriately variable within a permissible range.

### EFFECT OF THE INVENTION

According to the first to third aspect of the present invention, an alumina based sintered body having excellent mechanical properties such as bending strength and fracture toughness is used as a material, while the surface of the material exposed to a plasma is coated with an oxide or a composite oxide of a group IIIA element in the periodic table being excellent in plasma resistance. In addition, an intermediate layer is inserted between the material and the surface layer containing the oxide or composite oxide of the group IIIA element in the periodic table in order to relax the differences of thermal expansion or contraction between the material and oxide coating layer, or in order to enhance adhesive property between the two layers. As a result, the mechanical strength was reinforced while enabling a plasma resistant member sufficiently durable to exposure to a low pressure high density plasma to be realized.

According to the second aspect of the present invention, a member excellent in plasma resistance can be also realized by forming a layer of a sintered body comprising an oxide or a composite oxide of a group IIIA element in the periodic table having a specified porosity on the surface of the alumina based material.

The plasma resistant member according to the present invention can contribute to a long service life of a semiconductor manufacturing apparatus in use of the member to be exposed to a plasma atmosphere, because the member is highly durable by eliminating incidence of peeling of the coating layer by the influence and action of heat, and occurrence of damage and fracture during the cleaning step.

Improved reliability and yield of semiconductors may be expected by removing potential contamination with particles. Accordingly, the plasma resistant member according to the present invention is effective for manufacturing and processing of high performance and reliable semiconductors without any adverse effect on the quality and accuracy of film deposition while suppressing the manufacturing cost of the semiconductor manufacturing apparatus and semiconductor itself.

## Claims

1. A plasma resistant member, wherein at least a surface of an alumina based material to be exposed to plasma is formed a surface layer including an oxide or a composite compound of a group IIIA element in the periodic table, and means for absorbing a thermal expansion difference between the surface layer and the alumina base material is provided.

2. A plasma resistant member according to claim 1, wherein at least the surface to be exposed to a plasma comprises a surface layer including an oxide or a composite oxide of a group IIIA element in the periodic table via an intermediate layer.

3. A plasma resistant member according to claim 2, wherein the intermediate layer comprises 10 to 80% by weight of an oxide or a composite oxide of a group IIIA element in the periodic table and 90 to 20% by weight of alumina.

4. A plasma resistant member according to any one of claims 1 to 3, wherein the difference of the thermal shrinkage ratio between the alumina based material and the layer containing the oxide or composite oxide of the Group IIIA element in the periodic table formed on the surface of the alumina based material is 3% or less at 1600 to 1900°C.

5. A plasma resistant member comprising an alumina based material and at least a surface to be exposed to a plasma, the surface comprising a surface layer including an oxide or a composite oxide of a group IIIA element in the periodic table, and means for absorbing thermal expansion difference being provided between the alumina based material and the surface layer, wherein the content of the oxide or composite oxide of the group IIIA element in the periodic table in the surface layer is 70% by weight or more.

6. A plasma resistant member according to claim 5, wherein at least the surface to be exposed to a plasma comprises a surface layer including an oxide or a composite oxide of a group IIIA element in the periodic table via an intermediate layer, the content of the oxide or composite oxide of the group IIIA element in the periodic table in the surface layer being 70% by weight or more.

7. A plasma resistant member according to claim 5 or 6, wherein the content of an oxide or a composite oxide of a group IIIA element in the periodic table in the intermediate layer and/or surface layer is continuously changed in the direction of depth of each layer.

8. A plasma resistant member according to claim 7, wherein the rate of change of the content of the oxide or composite oxide of the group IIIA element in the periodic table at every 50 µm in the depth direction is 30% or less in the intermediate layer and/or surface layer.

9. A plasma resistant member comprising an alumina based material, a dense surface layer with a porosity of 0.1% or less containing an oxide or a composite oxide of a group IIIA element in the periodic table, and an intermediate layer comprising an inexact mass ceramic layer with a porosity of 0.2 to 5% located between these two layers.

10. A plasma resistant member according to claim 9, wherein the surface layer containing the oxide or the composite oxide of the group IIIA element in the periodic table has a thickness of 0.01 to 0.50 mm.

11. A plasma resistant member comprising an alumina based material and a surface layer including an oxide or a composite oxide of a Group IIIA element in the periodic table formed on the surface of the alumina based material, wherein the surface layer containing the oxide or a composite oxide of the Group IIIA element in the periodic table formed on the surface of the alumina based material has a porosity of 0.2 to 5%.

12. A plasma resistant member according to claim 11, wherein the surface layer containing the oxide or a composite oxide of the Group IIIA element in the periodic table formed on the surface of the alumina based material has a thickness of 0.01 to 0.50 mm.
